(19) **Europäisches Patentamt**

**European Patent Office**

**Office européen des brevets**

(11) Veröffentlichungsnummer: **0 110 358**
**A2**

(12) **EUROPÄISCHE PATENTANMELDUNG**

(21) Anmeldenummer: **83111862.5**

(22) Anmeldetag: **26.11.83**

(51) Int. Cl.³: **H 03 K 17/60**

(30) Priorität: **27.11.82 DE 3244056**

(43) Veröffentlichungstag der Anmeldung: **13.06.84**
**Patentblatt 84/24**

(84) Benannte Vertragsstaaten: **CH DE FR GB LI SE**

(71) Anmelder: **Philips Kommunikations Industrie AG,**
**Thurn-und-Taxis-Strasse 10, D-8500 Nürnberg 10 (DE)**

(84) Benannte Vertragsstaaten: **DE**

(71) Anmelder: **N.V. Philips' Gloeilampenfabrieken,**
**Groenewoudseweg 1, NL-5621 BA Eindhoven (NL)**

(84) Benannte Vertragsstaaten: **CH FR GB LI SE**

(72) Erfinder: **Reichle, Michael, Heidestrasse 20,**
**D-8501 Eckenhaid (DE)**

(74) Vertreter: **Peuckert, Hermann et al, Philips**
**Patentverwaltung GmbH**
**Billstrasse 80 Postfach 10 51 49,**
**D-2000 Hamburg 28 (DE)**

(54) Schaltungsanordnung zur Ansteuerung eines stromgesteuerten Bauelementes.

㉗ Bei einer Schaltungsanordnung zur Ansteuerung eines stromgesteuerten Bauelementes liegen das stromgesteuerte Bauelement, ein steuerbarer Widerstand und eine Stromquelle in Reihe. Parallel zu der Reihenschaltung, bestehend aus dem steuerbaren Widerstand und dem stromgesteuerten Bauelement, liegt ein Stromzweig, der eine Kapazität enthält.

Philips Kommunikations
Industrie AG

PHT 82-344 EP

N.V. Philips'Gloeilampenfabrieken

Schaltungsanordnung zur Ansteuerung eines stromgesteuerten Bauelementes

---

Die Erfindung betrifft eine Schaltungsanordnung zur
Ansteuerung eines stromgesteuerten Bauelementes gemäß Oberbegriff des Anspruches 1.

Stromgesteuerte Bauelemente sind z.B. Laser und Licht
emittierende Dioden, die als Sendeelemente in der
optischen Nachrichtenübertragung mit Lichtwellenleitern als Übertragungsmedium verwendet werden. Dabei wird die Lichtintensität des Lasers bzw. der
Licht emittierenden Diode vom Eingangssignal moduliert. In der digitalen optischen Nachrichtenübertragung entspricht die Aussendung von Licht beispielsweise einer logischen 1, während eine logische 0 vorliegt, wenn kein Licht ausgesendet wird.

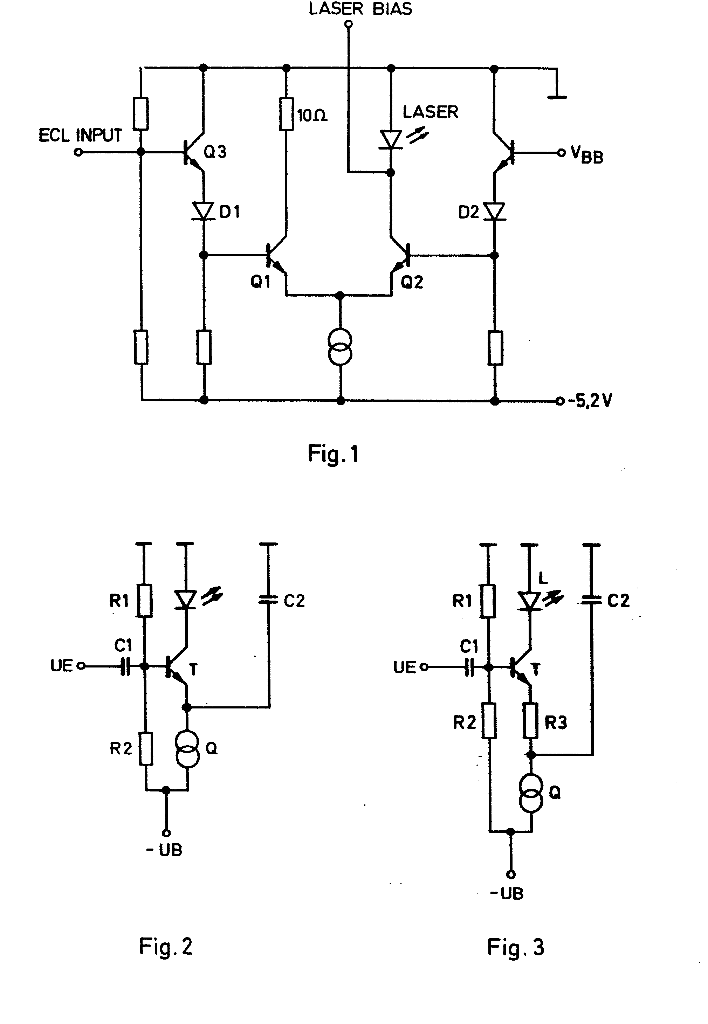

In The Bell Systems, Techn. Journal, Vol. 57, No. 6,
July-August 1978 ist auf Seite 1823 bis 1833 in dem
Aufsatz "GaAlAs Laser Transmitter for Lightwave
Transmission Systems" von Shumate, Chen und Dorman
ein Lasersender für optische Übertragungssysteme beschrieben. In der Fig. 2 auf Seite 1826 ist eine
Schaltungsanordnung zur Ansteuerung eines Laser gezeigt, die hier in Fig. 1 dargestellt ist. Über eine
Übertragungsstufe mit einem Transistor $Q_3$ wird das
Eingangssignal dem einen Eingang eines Differenzverstärkers zugeführt, der aus zwei Transistoren $Q_1$ und
$Q_2$ aufgebaut ist. Der andere Eingang des Differenzverstärkers liegt an einer Referenzspannung. In der

0110358

PHT 82-344 EP

Kollektor-Zuleitung des Transistors $Q_1$ liegt ein Widerstand mit einem Wert von $10\,\Omega$, während in der Kollektor-Zuleitung des Transistors $Q_2$ der Laser angeordnet ist. Die Emitter der beiden Transistoren $Q_1$ und $Q_2$ sind an den einen Ausgang einer Stromquelle angeschlossen. Wenn der Laser Licht aussenden soll, wird der Transistor $Q_2$ aufgesteuert, der Transistor $Q_1$ dagegen gesperrt, so daß die Stromquelle über die Emitter-Kollektor-Strecke des Transistors $Q_2$ mit dem Laser verbunden ist. Soll kein Licht ausgesendet werden, d.h. es liegt eine Impulspause vor, sperrt der Transistor $Q_2$, dagegen ist der Transistor $Q_1$ geöffnet, so daß die Stromquelle nicht im Leerlauf betrieben wird, sondern der Stromkreis über die Emitter-Kollektor-Strecke des Transistors $Q_1$ und den Widerstand mit dem Wert $10\,\Omega$ geschlossen ist.

Ein Nachteil dieser bekannten Schaltungsanordnung ist in der relativ hohen Verlustleistung zu sehen, denn während der Impulspausen fließt der Strom, den die Stromquelle liefert, nicht durch den Laser, sondern durch den Widerstand von $10\,\Omega$, in dem nun ohmsche Verluste auftreten.

Es ist daher Aufgabe der Erfindung, eine Schaltungsanordnung mit geringer Verlustleistung zur Ansteuerung eines stromgesteuerten Bauelementes anzugeben.

Die Erfindung löst diese Aufgabe mit den kennzeichnenden Merkmalen des Anspruches 1.

In den Unteransprüchen sind vorteilhafte Ausgestaltungen der Erfindung angegeben.

0110358

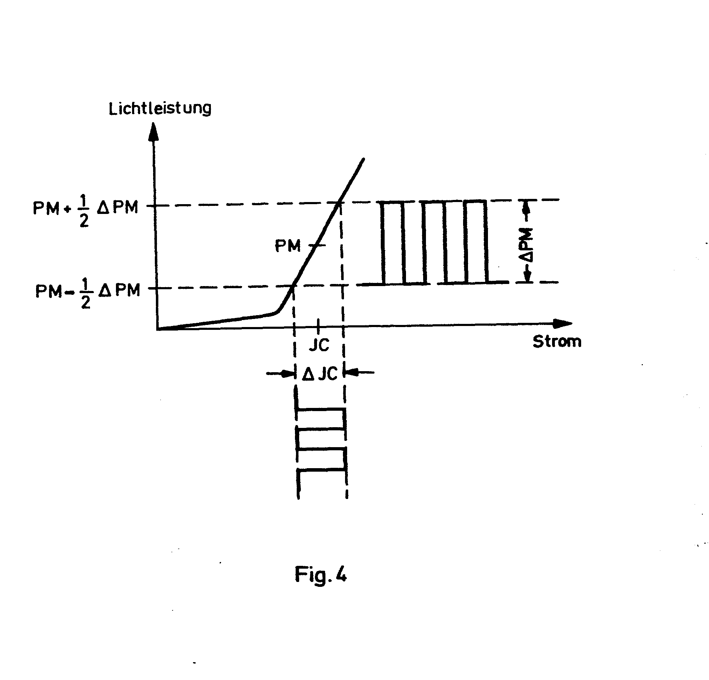

Es zeigen die Fig. 2 ein erstes und die Fig. 3 ein
zweites Ausführungsbeispiel der Erfindung, während
in der Fig. 4 die Kennlinie eines Lasers dargestellt
ist.

In der Fig. 2 wird das Eingangssignal UE über eine
Kapazität C1 der Basis eines Transistors T zugeführt,
die über einen Widerstand R1 an Masse und über einen
Widerstand R2 an der Versorgungsspannung -UB liegt.
Der Ermitter des Transistors T ist über eine Stromquelle Q mit der Versorgungsspannung -UB verbunden,
während sein Kollektor über einen Laser oder eine
Licht emittierende Diode L, im weiteren Verlauf LED
genannt, an Masse liegt. Eine Kapazität C2 verbindet
den Emitter des Transistors T mit Masse.

Die Widerstände R1 und R2 dienen der Arbeitspunkteinstellung des Transistors T. Das digitale Eingangssignal UE, das der Basis des Transistors T über die
Kapazität C1 zugeführt wird (Wechselspannungskopplung),
moduliert die Lichtintensität des Lasers bzw. der LED.

Während der Aussendung eines Lichtimpulses durch den
Laser bzw. die LED ist der Transistor geöffnet, dagegen ist er während einer Impulspause gesperrt, so
daß der Strom aus der Stromquelle Q als Ladestrom in
die Kapazität C2 fließt. Zur nächsten Aussendung eines
Lichtimpulses wird der Transistor wieder leitend. Den
Strom für den Laser bzw. die LED liefern nun die Stromquelle Q und die geladene Kapazität C2 gemeinsam. In der
darauf folgenden Impulspause wird die Kapazität C2 wieder
von der Stromquelle Q aufgeladen.

Weil während der Impulspausen der Strom aus der Stromquelle nicht in einem Widerstand ohmsche Verluste erzeugt, sondern dem Aufladen einer Kapazität dient und bei jedem auf eine Impulspause folgenden Impuls wieder an den Laser bzw. die LED abgegeben wird, braucht die Stromquelle nur noch die Hälfte desjenigen Stromes zu liefern, den sie in der bekannten Schaltungsanordnung liefern müßte. Mit anderen Worten heißt dies, daß bei Betrieb des Transistors als Schalter nur noch die halbe Leistung verbraucht wird.

Bei einem stromgesteuerten Bauelement mit Schwellwert, wie z.B. bei einem Laser, kann es bei hochfrequenten Eingangssignalen sinnvoll sein, den Transistor nicht vollständig zu sperren, sondern einen Vorstrom durch das stromgesteuerte Bauelement zu schicken, wie anhand der Kennlinie eines Lasers, die in Fig. 4 gezeigt ist, im folgenden erläutert wird.

Um eine genügend hohe Lichtintensität zu erzielen, ist es nötig, den Laser im steilen Teil der Kennlinie nach dem Knick zu betreiben. Hierzu wird eine mittlere Leistung PM als Arbeitspunkt festgelegt, um den herum die abgegebene Lichtleistung schwankt. Der Punkt PM wird durch den Ruhestrom IC festgelegt. Dem Ruhestrom IC überlagert sich nun noch der halbe Pulsstrom $1/2 \Delta IC$, der den Schwankungen $\Delta UE$ der Eingangsspannung UE proportional ist. Die Kapazität C2 nimmt während einer Impulspause im Eingangssignal den halben Pulsstrom $1/2 \Delta IC$ auf, den sie während des nächsten Impulses wieder an den Laser abgibt. Wie der Kollektorstrom durch den Transistor und auch durch den Laser deshalb die Werte

IC + 1/2 $\Delta$IC und IC - 1/2 $\Delta$IC annimmt, so sendet der
Laser Licht mit den Intensitäten PM + 1/2 $\Delta$PM und
PM - 1/2 $\Delta$PM aus. Dabei entsprechen der Strom
IC + 1/2 $\Delta$IC und die Lichtintensität PM + 1/2 $\Delta$PM
einem Impuls, während der Strom IC - 1/2 $\Delta$IC und die
Lichtintensität PM - 1/2 $\Delta$PM eine Impulspause darstellen. Der Pulsstrom $\Delta$IC hängt nach folgender Formel
vom Ruhestrom IC ab:

$$\Delta IC = \frac{IC}{UT} \cdot \Delta UE$$

wobei UT die Thermospannung des Transistors ist.

Die Abhängigkeit des Pulsstromes $\Delta$IC vom Ruhestrom IC
läßt sich durch Gegenkopplung verringern.

Das in der Fig. 3 gezeigte Ausführungsbeispiel unterscheidet sich topologisch von dem in der Fig. 2 gezeigten nur durch einen Gegenkopplungswiderstand R3,
der zwischen der Stromquelle Q und dem Emitter des
Transistors T liegt. Die Kapazität C2 liegt parallel
zu der Reihenschaltung aus dem Laser L, der Kollektor-
Emitter-Strecke des Transistors T und dem Gegenkopplungswiderstand R3. Der Pulsstrom $\Delta$IC hängt in diesem Fall
nach folgender Formel von Ruhestrom IC ab:

$$\Delta IC = \frac{1}{\frac{UT}{IC} + R3} \cdot \Delta UE$$

Die Abhängigkeit des Pulsstromes $\Delta$IC vom Ruhestrom IC
ist somit um den Faktor $\dfrac{1}{1 + \dfrac{R3 \cdot UT}{IC}}$ verringert.

0110358

Philips Kommunikations
Industrie AG

N.V. Philips'Gloeilampenfabrieken

Patentansprüche

1. Schaltungsanordnung zur Ansteuerung eines stromgesteuerten Bauelementes (L), bei der das stromgesteuerte Bauelement (L), ein steuerbarer Widerstand (T) und eine Stromquelle (Q) in Reihe
liegen, dadurch gekennzeichnet, daß parallel zu
der Reihenschaltung, bestehend aus dem steuerbaren Widerstand (T) und dem stromgesteuerten
Bauelement (L), ein Stromzweig mit einer ersten
Kapazität (C2) vorgesehen ist.

2. Schaltungsanordnung nach Anspruch 1, dadurch gekennzeichnet, daß das stromgesteuerte Bauelement
(L) ein Laser oder eine Licht emittierende Diode
ist.

3. Schaltungsanordnung nach Anspruch 1 oder 2, dadurch
gekennzeichnet, daß der steuerbare Widerstand (T)
ein Transistor ist.

4. Schaltungsanordnung nach Anspruch 3, dadurch gekennzeichnet, daß der Transistor (T) als Schalter
betrieben wird.

5. Schaltungsanordnung nach Anspruch 2, 3 oder 4,
dadurch gekennzeichnet, daß die Stromquelle (Q)
in der Emitterzuleitung des Transistors (T) liegt,
während das stromgesteuerte Bauelement (L) in der
Kollektorzuleitung liegt.

6. Schaltungsanordnung nach Anspruch 3, 4 oder 5, _dadurch gekennzeichnet_, daß das Eingangssignal über eine zweite Kapazität (Cl) der Basis des Transistors (T) zugeführt wird.

7. Schaltungsanordnung nach Anspruch 1, 2, 3, 4, 5 oder 6, _dadurch gekennzeichnet_, daß ein Gegenkopplungswiderstand (R3) zwischen dem steuerbaren Widerstand (T) und der Stromquelle (Q) liegt und daß die erste Kapazität (C2) parallel zu der Reihenschaltung bestehend aus dem stromgesteuerten Bauelement (L), dem steuerbaren Widerstand (T) und dem Gegenkopplungswiderstand (R3) liegt.

1/2

0110358

Fig. 1

Fig. 2

Fig. 3

0110358

**Fig. 4**